# FASCICULE DE BREVET EUROPEEN

(11) **EP 0 946 461 B1**
(45) Date de publication et mention de la délivrance du brevet: **26.03.2003**
(21) Numéro de dépôt: 97911283.6
(22) Date de dépôt: 17.10.1997
(51) Int. Cl.: C04B 35/83, C04B 35/80, C23C 16/04, C23C 16/44, C23C 16/46, F16D 69/02

(54) **DENSIFICATION DE SUBSTRATS POREUX DISPOSES EN PILES ANNULAIRES PAR INFILTRATION CHIMIQUE EN PHASE VAPEUR A GRADIENT DE TEMPERATURE**
VERDICHTUNG RINGFÖRMIG ANGEORDNETER PORÖSER SUBSTRATE MITTELS CHEMICHER DAMPFINFILTRATION MIT TEMPERATURGRADIENT
DENSIFICATION OF SUBSTRATES ARRANGED IN RING-SHAPED STACKS BY CHEMICAL INFILTRATION IN VAPOUR PHASE WITH TEMPERATURE GRADIENT

(30) Priorité: 18.10.1996 FR 9612692
(43) Date de publication de la demande: 06.10.1999
(73) Titulaire: SOCIETE NATIONALE D'ETUDE ET DE CONSTRUCTION DE MOTEURS D'AVIATION, 75015 Paris (FR)
(72) Inventeur: CHRISTIN, François, F-33160 Saint Aubin de Médoc (FR); DOMBLIDES, Jean-Luc, F-33520 Bruges (FR); GOUJARD, Stéphane, F-33700 Mérignac (FR); LELUAN, Jean-Luc, F-33200 Bordeaux (FR); ROBIN-BROSSE, Christian, F-33185 Le Haillan (FR); THEBAULT, Jacques, F-33200 Bordeaux (FR)
(74) Mandataire: Joly, Jean-Jacques
(86) Numéro de dépôt international: FR9701858
(87) Numéro de publication internationale: WO98017599

(56) Documents cités:
- WO-A-87/04733
- WO-A-95/11869
- WO-A-96/33295
- US-A- 5 221 354
- US-A- 5 348 774
- US-A- 5 480 678

## Description

La présente invention concerne un procédé d'infiltration chimique en phase vapeur pour la densification de substrats poreux disposés en piles annulaires, c'est-à-dire des substrats ayant sensiblement une forme de révolution avec un passage ou ouverture central et qui sont disposés en au moins une pile délimitant un passage intérieur formé par les ouvertures centrales des substrats.

Le domaine d'application de l'invention est notamment la fabrication de pièces en matériau composite comprenant un substrat, ou préforme, poreux densifié par une matrice, en particulier la fabrication de disques de frein en matériau composite par densification de préformes fibreuses annulaires.

Pour la fabrication de pièces en matériau composite, en particulier de pièces en matériau composite thermostructural constituées d'une préforme fibreuse en fibres réfractaires (fibres carbone ou céramique, par exemple) densifiée par une matrice réfractaire (carbone ou céramique, par exemple), il est courant de faire appel à des procédés d'infiltration chimique en phase vapeur. Des exemples de telles pièces sont des disques de freins, notamment de freins d'avions, en composite carbone-carbone (C-C).

La densification de substrats poreux par infiltration chimique en phase vapeur consiste à placer les substrats dans une chambre de réaction d'une installation d'infiltration et à admettre dans la chambre une phase gazeuse dont un ou plusieurs constituants forment un précurseur du matériau de la matrice à déposer au sein des substrats pour assurer leur densification. Les conditions d'infiltration, notamment composition et débit de la phase gazeuse, et température et pression dans la chambre, sont choisies pour permettre une diffusion de la phase gazeuse au sein de la porosité interne accessible des substrats afin que le matériau désiré y soit déposé par décomposition d'un constituant de la phase gazeuse ou réaction entre plusieurs constituants de celle-ci.

Les conditions d'infiltration chimique en phase vapeur du carbone pyrolytique, ou pyrocarbone, sont connues depuis longtemps de l'homme de l'art. Le précurseur du carbone est un alcane, un alkyle ou un alcène, généralement du propane, du méthane ou un mélange des deux. L'infiltration est réalisée à une température d'environ 1000°C sous une pression par exemple d'environ 1 kPa. Les conditions d'infiltration chimique en phase vapeur de matériaux autres que le carbone, notamment de matériaux céramiques, sont également bien connues. On pourra en particulier se référer au document FR-A-2 401 888.

Dans une installation industrielle d'infiltration chimique en phase vapeur, il est habituel de charger la chambre de réaction avec plusieurs substrats ou préformes à densifier simultanément, en utilisant un outillage de support. Lorsque les préformes sont annulaires, elles peuvent être disposées en pile(s) dans une direction longitudinale de la chambre de réaction. Les substrats sont portés à la température voulue par chauffage produit par un suscepteur généralement en graphite qui délimite le volume interne de la chambre et qui forme un induit couplé électromagnétiquement avec un inducteur situé à l'extérieur de la chambre. La phase gazeuse contenant le ou les précurseurs de matériau à déposer au sein des préformes est admise à une extrémité longitudinale de la chambre, tandis que les gaz résiduels sont évacués à l'extrémité opposée d'où ils sont extraits par des moyens de pompage. La phase gazeuse est généralement préchauffée avant d'atteindre les préformes à densifier, par exemple par passage à travers des plateaux de préchauffage perforés.

L'infiltration chimique en phase vapeur est un processus de longue durée. Afin de satisfaire des impératifs de production à l'échelle industrielle, il est souhaité de pouvoir densifier simultanément un nombre de substrats aussi élevé que possible, tout en faisant en sorte, que les substrats soient densifiés de la même façon. En particulier, il est nécessaire que tous les substrats parviennent à un même degré de densification avec une matrice ayant une même microstructure.

A cet effet, il est proposé dans le document WO-A-96/33295 de disposer des préformes annulaires en une ou plusieurs piles qui s'étendent dans la direction longitudinale de la chambre de réaction et délimitent chacune un passage intérieur longitudinal. Les préformes dans chaque pile sont espacées mutuellement par des entretoises qui ménagent des espaces entre préformes tout en permettant le passage de la phase gazeuse entre l'intérieur et l'extérieur de la pile. La phase gazeuse, de préférence préchauffée, est canalisée vers l'un des deux volumes constitués par l'intérieur, ou l'extérieur, de la ou chaque pile, à une extrémité longitudinale de la chambre de réaction, le volume vers lequel la phase gazeuse est canalisée étant fermé à l'autre extrémité longitudinale de la chambre. La circulation de la phase gazeuse entre l'admission dans la chambre et l'évacuation hors de la chambre se fait de l'intérieur vers l'extérieur de la ou chaque pile, ou inversement, la phase gazeuse passant à travers les espaces entre préformes et diffusant au sein de celles-ci, l'intérieur et l'extérieur de la ou chaque pile étant maintenus en équipression.

Un autre solution décrite dans le document US-A-5 480 678 consiste aussi à disposer des préformes annulaires en une pile qui s'étend dans la direction longitudinale de la chambre de réaction et délimite un passage intérieur longitudinal. Les préformes sont espacées mutuellement par des entretoises annulaires qui entourent complètement les ouvertures centrales des préformes. La phase gazeuse préchauffée est admise à une extrémité du passage intérieur longitudinal de la pile, lequel passage est fermé à son extrémité opposée. Il s'établit ainsi une différence de pression entre l'intérieur et l'extérieur de la pile forçant la phase gazeuse à traverser les préformes, aucun passage de fuite n'étant ménagé par les entretoises séparant les préformes.

L'installation d'infiltration chimique en phase vapeur isobare à flux dirigé et l'installation à gradient de pression à flux forcé évoquées ci-avant permettent de traiter un assez grand nombre de substrats poreux de façon sensiblement uniforme. Il est toutefois souhaitable d'apporter des améliorations, en particulier afin de réduire l'inhomogénéité de densification de chaque substrat.

En effet, si les substrats sont densifiés sensiblement de la même façon, un gradient de densification est observé au sein de chaque substrat, les zones des substrats éloignées des surfaces exposées en premier à la phase gazeuse étant moins densifiées. Il s'agit d'un phénomène bien connu, les zones des substrats dans lesquelles la phase gazeuse diffuse d'abord ayant tendance à se densifier plus rapidement. Il peut même se produire une obturation prématurée de la porosité au niveau des surfaces exposées en premier à la phase gazeuse, avant que le niveau souhaité de densification soit atteint au coeur des préformes. Il est alors nécessaire d'interrompre le processus de densification, de retirer les substrats partiellement densifiés de l'installation d'infiltration et de procéder à des opérations d'usinage, ou écroûtage, afin de rouvrir la porosité superficielle. Outre qu'elles augmentent de façon sensible la durée totale de la densification et entraînement des pertes de matière substantielles, ces opérations d'écroûtage imposent la réalisation de substrats ayant des dimensions supérieures à celles des pièces à réaliser, donc encombrants. Le taux de chargement des substrats à l'intérieur de la chambre de réaction est alors inférieur à ce qu'il pourrait être si des écroûtages n'étaient pas à réaliser.

Afin d'éviter ces inconvénients, il est proposé dans le document PCT/US 95/15039 de modifier le processus décrit dans US-A-5 480 678 en réalisant la densification en deux étapes, une première étape à gradient de pression et à flux forcé, comme dans US-A-5 480 678, et une deuxième étape soit par infiltration chimique en phase vapeur isotherme isobare, soit en inversant la direction du flux forcé de phase gazeuse par rapport aux substrats, soit par densification par voie liquide (imprégnation par un précurseur de la matrice à l'état liquide et transformation du précurseur par traitement thermique). Il en résulte une certaine complication du processus global de densification, en particulier si celui-ci doit être interrompu et les substrats partiellement densifiés doivent être retirés de la chambre de réaction entre les deux étapes de densification.

La présente invention a pour but d'améliorer la densification par infiltration chimique en phase vapeur de substrats poreux disposés en piles annulaires, afin de réduire l'inhomogénéité de densification des substrats individuels, sans nécessité de conduire la densification en deux étapes distinctes.

Ce but est atteint grâce à un procédé du type comprenant :
- le chargement des substrats à densifier à l'intérieur d'une chambre de réaction d'une installation d'infiltration, les substrats étant disposés en au moins une pile annulaire qui s'étend dans une direction longitudinale de la chambre et qui délimite un passage intérieur avec des espaces ménagés entre des substrats;
- le chauffage des substrats ;
- l'admission, au voisinage d'une première extrémité longitudinale de la chambre de réaction, d'une phase gazeuse contenant au moins un précurseur du matériau à déposer ;
- la canalisation de la phase gazeuse admise dans la chambre de réaction vers l'un des deux volumes constitués par l'intérieur et l'extérieur de la ou des piles de substrats, à son extrémité la plus proche de la première extrémité longitudinale de la chambre, le volume dans lequel la phase gazeuse est canalisée étant fermé à son extrémité la plus éloignée de la première extrémité longitudinale de la chambre ; et
- l'évacuation de gaz résiduels hors de la chambre de réaction ; procédé dans lequel, conformément à l'invention,
- les substrats sont chauffés de façon non uniforme par couplage indentif direct avec un inducteur entourant la pile, avec établissement d'un gradient de température au sein de chaque substrat, de sorte que des parties des substrats éloignées de leurs surfaces exposées à la phase gazeuse admise aient une température supérieure à celle des surfaces exposées.

Le processus d'infiltration chimique en phase vapeur avec gradient de température au sein des substrats à densifier est bien connu, en particulier afin de s'opposer à l'établissement d'un gradient de densification et à une obturation prématurée de la porosité au niveau des surfaces des substrats exposées à la phase gazeuse. Le principe en est décrit en particulier dans un article de WV Kotlensky intitulé "A review of CVD carbon infiltration of porous substrates", 16th National SAMPE Symposium, 21 avril 1971, Anaheim, USA.

Alors que les processus d'infiltration chimique en phase vapeur à gradient de température ont été décrits en relation avec la densification de substrats unitaires, la déposante a pu mettre en évidence que, de façon surprenante, des processus de ce type peuvent parfaitement être mis en oeuvre avec une pluralité de substrats disposés en piles annulaires sans requérir de moyens complexes pour le chauffage hétérogène des substrats.

Le chauffage est réalisé par couplage inductif direct entre un inducteur et les substrats à densifier, ceux-ci étant en une matière conductrice de l'électricité. Par couplage inductif direct, on entend ici un couplage entre l'inducteur et, exclusivement, les substrats à densifier, sans utiliser d'induit ou suscepteur séparé. Des procédés d'infiltration chimique en phase vapeur avec couplage direct entre un inducteur et un substrat en fibres conductrices de l'électricité, notamment en fibres de carbone ou graphite, ou en fibres revêtues de carbone ou de graphite, sont décrits dans les documents WO-A-95/11867, WO-A-95/11868 et WO-A-95/11869 de la demanderesse.

Un inducteur est disposé autour de la ou chaque pile annulaire de substrats, de préférence à l'intérieur de la chambre de réaction. Il est alors par exemple constitué par une bobine d'induction refroidie noyée dans un isolant thermique, tel qu'un ciment. De la sorte, un échauffement préjudiciable de la bobine est évité, et l'ensemble constitué par la bobine et l'isolant est à une température trop basse pour que des dépôts parasites provenant de la phase gazeuse puissent s'y former. En outre, un refroidissement des faces des substrats situées au regard de l'inducteur refroidi favorise l'établissement d'un gradient thermique avec les zones les plus chaudes situées au coeur des substrats, en débit de l'effet de peau inhérent au couplage inductif.

La fréquence d'alimentation de l'inducteur est choisie en fonction de l'emplacement désiré pour les parties les plus chaudes des substrats, en tenant compte de l'effet de peau, des caractéristiques électriques et thermiques des substrats et du refroidissement des surfaces des substrats par radiation et/ou convection. Cette fréquence est typiquement comprise entre 150 Hz et 10 000 Hz, de préférence entre 1 000 et 2 000 Hz.

De préférence, le volume dans lequel la phase gazeuse est canalisée est fermé par un isolant thermique à son extrémité la plus éloignée de celle où la phase gazeuse est admise. De la sorte, on évite des déperditions thermiques en bout de pile et on maintient des mêmes conditions de température des substrats d'un bout à l'autre de la pile dans la direction longitudinale de la chambre de réaction.

Le procédé selon l'invention est remarquable en ce que la densification est réalisée en une seule fois, sans interruption, c'est-à-dire sans nécessiter un arrêt intermédiaire pour réaliser un écroûtage des substrats ou pour passer d'une première à une deuxième phase de densification.

L'absence d'écroûtage permet en outre d'utiliser des substrats dont les dimensions sont proches de celles des pièces à réaliser. La minimisation des surépaisseurs nécessaires, selon l'art antérieur, dans des parties des substrats destinées à être sacrifiées lors de l'écroûtage fait qu'à volume utile égal dans la chambre de réaction un plus grand nombre de substrats peuvent être densifiés simultanément.

Des modes de réalisation de l'invention seront décrits ci-après, à titre indicatif mais non limitatif, en référence aux dessins annexés sur lesquels :
- la figure 1 est une vue très schématique illustrant la mise en oeuvre d'un procédé conforme à l'invention pour une densification de substrats en pile annulaire avec flux dirigé de phase gazeuse réactionnelle
- la figure 2 est une vue d'un détail de la figure 1 ;
- la figure 3 est une courbe illustrant le gradient de température au sein d'un substrat de la figure 1 ;
- les figures 4 et 5 illustrent très schématiquement deux variantes du procédé illustré par la figure 1 ;
- la figure 6 est une vue très schématique illustrant la mise en oeuvre d'un procédé conforme à l'invention pour une densification de substrats en pile annulaire avec flux forcé de phase gazeuse réactionnelle ;
- la figure 7 est une vue d'un détail de la figure 6 ;
- la figure 8 est une courbe illustrant le gradient de température au sein d'un substrat de la figure 6 ;
- la figure 9 illustre très schématiquement une variante du procédé de la figure 6 ; et
- la figure 10 est une vue d'un détail de la figure 9.

Dans la description qui suit, on envisage la densification de substrats poreux constitués par des préformes annulaires de disques de frein en matériau composite carbone-carbone. Toutefois, le procédé selon l'invention peut être mis en oeuvre sur d'autres types de substrats, dès lors qu'il s'agit de substrats poreux présentant un passage ou ouverture central et susceptibles d'être disposés en pile annulaire.

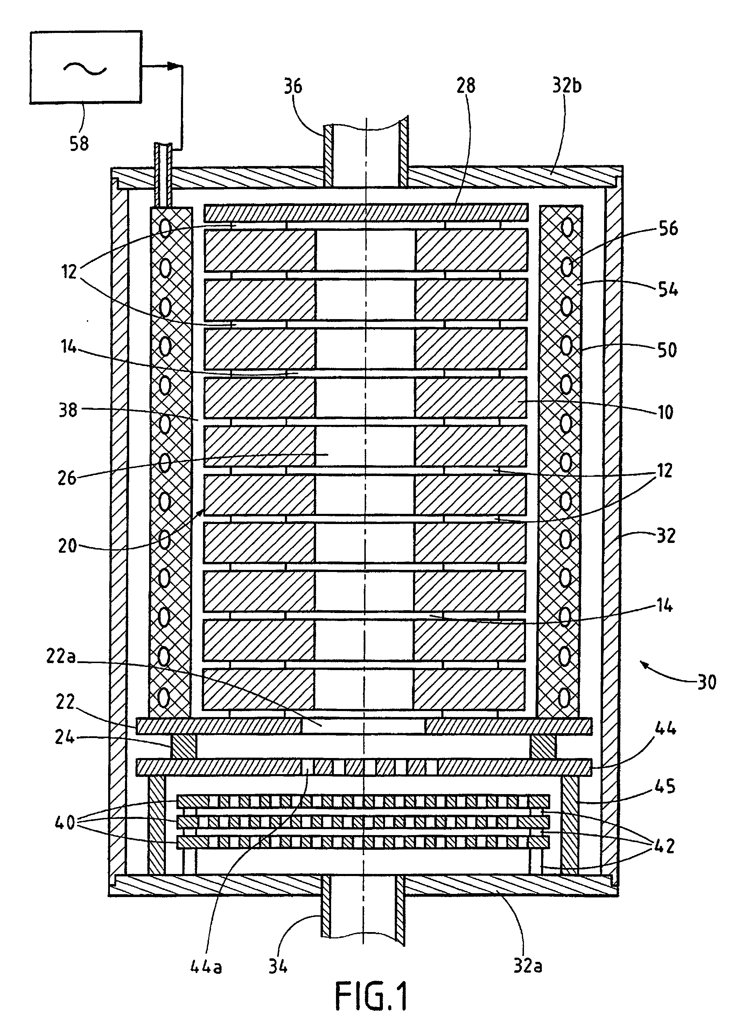

La figure 1 montre un changement de préformes annulaires poreuses 10 en fibres de carbone, destinées à être densifiées par une matrice de carbone pyrolytique, par exemple des préformes de disques de freins d'avions. Elles sont constituées de strates de fibres de carbone superposées et liées entre elles par aiguilletage. Un procédé de réalisation de préformes en fibres de carbone constituées de strates empilées à plat et aiguilletées est décrit notamment dans le document US-A-4 790 052.

Les préformes 10 sont disposées en une pile verticale 20 à l'intérieur d'une chambre de réaction 30 entourée par une enceinte 32 d'axe vertical munie d'un fond 32a et d'un couvercle 32b.

La phase gazeuse contenant un ou plusieurs précurseurs du carbone est introduite dans la chambre 30 par une conduite d'alimentation 34 traversant le fond 32a. La phase gazeuse donnant du carbone pyrolytique est par exemple constituée de propane et de gaz naturel, précurseurs du carbone. Les gaz résiduels sont extraits à la partie supérieure de la chambre 30, au moyen d'une conduite d'évacuation 36 traversant le couvercle 32b. La conduite d'évacuation 36 est reliée à un dispositif de pompage (non représenté) permettant d'établir la pression désirée dans la chambre.

La phase gazeuse pénétrant dans la chambre 30 est éventuellement préchauffée par passage à travers des plateaux de préchauffage perforés 40 espacés les uns des autres et du fond 32a par des entretoises 42. Les plateaux 40 et entretoises 42 sont par exemple en graphite.

La phase gazeuse préchauffée peut passer à travers un plateau diffuseur 44 qui repose sur le fond 32a par l'intermédiaire d'un pied 45 en forme de couronne. Le plateau diffuseur 44 présente une pluralité de passages 44a régulièrement espacés afin de répartir la phase gazeuse de façon uniforme.

La pile 20 repose sur un plateau support 22 qui repose sur le plateau diffuseur 44 par l'intermédiaire d'une cale annulaire 24. Le plateau support 22 est muni d'un trou central 22a. Les préformes empilées 10 sont alignées verticalement avec le trou 22a qui a un diamètre égal ou légèrement supérieur au diamètre interne des préformes 10. Ainsi, la pile 20 de préformes alignées verticalement définit un passage central 26 en forme de cheminée constitué par les ouvertures centrales des préformes. Le passage 26 est obturé à sa partie supérieure par un écran plein 28.

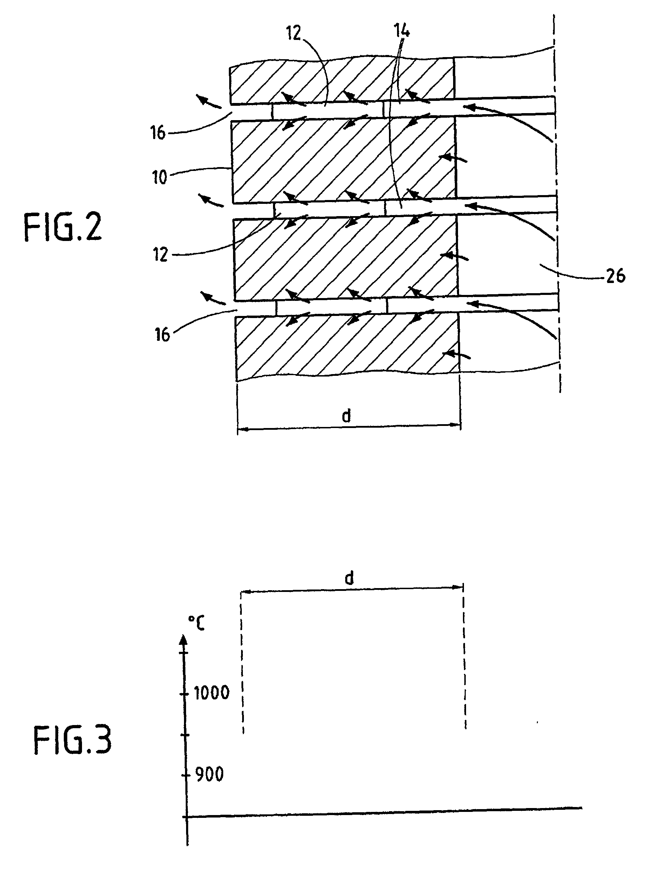

Les éléments intercalaires 12, ou entretoises, de faible épaisseur, sont disposés dans la pile 20 entre les préformes 10 ou au moins entre des groupes de préformes empilées. Les entretoises 12 se présentent par exemple sous forme de barrettes disposées radialement ménageant une communication entre l'intérieur et l'extérieur de la pile. Des entretoises semblables sont aussi disposées entre le plateau support 22 et la première préforme qui repose sur celui-ci, et entre l'écran 28 et la dernière préforme de la pile 20. Chaque espace 14 ainsi ménagé par les entretoises 12 offre des passages de fuite 16 pour la phase gazeuse entre l'intérieur et l'extérieur de la pile 20 (figure 2). Ainsi, la pression entre le passage central 26 et le volume interne de la chambre 30 est équilibrée et la phase gazeuse peut diffuser au sein des préformes 10 à partir des faces planes principales de celles-ci.

La phase gazeuse préchauffée issue du plateau diffuseur 44 est canalisée vers le volume constitué par le passage central 26 de la pile 20. A cet effet, la cale 24 disposée entre le plateau support 22 et le plateau diffuseur 44 est une bague pleine de diamètre interne égal ou supérieur à celui du trou 22a et entoure celui-ci. Le plateau diffuseur 44 est muni de perforations uniquement au regard du passage 26. La phase gazeuse canalisée dans le passage 26 circule de l'intérieur vers l'extérieur de la pile 20, et parvient dans le volume 38 de la chambre 30, extérieur à la pile 10, d'où elle est évacuée par la conduite d'évacuation 36.

Le chauffage des préformes à la température désirée pour réaliser l'infiltration chimique en phase vapeur est produit au moyen d'un inducteur 50 entourant la pile 20 à l'intérieur de la chambre 30, et de même axe vertical que la pile 20.

L'inducteur 50 repose sur le support 22 et comprend une bobine d'induction 52 noyée à l'intérieur d'un manchon 54 en matériau réfractaire isolant thermique, par exemple en un ciment. La bobine est par exemple formée par un enroulement creux 56 parcouru par un fluide de refroidissement, par exemple de l'eau et relié à un échangeur de chaleur (non représenté) à l'extérieur de la chambre 30. La bobine 52 est alimentée électriquement par liaison à un circuit d'alimentation 58. En variante, il est possible d'utiliser pour la bobine un conducteur plein, et de loger un circuit de refroidissement séparé dans le manchon 54.

Avec cette disposition, le chauffage des préformes 10 est réalisé par couplage inductif direct entre chaque préforme et la bobine 52. Comme décrit dans le document WO-A-95/11869 déjà cité, des préformes fibreuses en fibres de carbone aiguilletées conviennent bien pour assurer un couplage direct satisfaisant, dès lors que le taux volumique de fibres, c'est-à-dire le pourcentage du volume des préformes effectivement occupé par les fibres, est de préférence d'au moins 20 %, voire au moins 25 %.

Il est bien connu que le chauffage d'un corps par induction est produit par effet Joule, par les courants induits, et que ceux-ci se concentrent en surface (effet de peau). Ce phénomène de concentration en surface est d'autant plus marqué que la fréquence du courant alimentant l'inducteur est élevée.

Dans le cas présent, en dépit de l'effet de peau, par le choix d'une fréquence convenable et en tenant compte du refroidissement des faces latérales des préformes par radiation au regard de l'inducteur refroidi, il est possible d'obtenir un gradient de température au sein des préformes ayant le profil illustré par la figure 3. Le long d'un rayon des préformes, entre la circonférence intérieure et la circonférence extérieure, la température croît d'une température Tm1 à une température Tmax, au voisinage du diamètre médian, et décroît ensuite jusqu'à une température Tm2.

La fréquence la plus adaptée pour obtenir une tel gradient dépend de plusieurs paramètres : nature exacte des fibres, dimension des préformes en direction radiale, valeurs de résistivité électrique et de conductivité thermique...

A titre indicatif, pour une préforme aiguilletée en fibres de carbone, la fréquence optimale se trouve dans la gamme d'environ 150 Hz à environ 10 000 Hz, selon le taux de fibres et la dimension radiale des préformes. La puissance fournie à l'inducteur est choisie pour que la température Tmax soit au moins égale à celle nécessaire à la formation d'un dépôt du matériau souhaité pour la matrice, par exemple maintenue à une valeur d'environ 1050°C avec le précurseur propane. Les température Tm1 et Tm2 peuvent présenter un écart d'au moins 100°C avec Tmax, au moins au début du processus d'infiltration. Au fur et à mesure de l'infiltration, le front de densification progresse depuis la circonférence médiane des préformes vers les circonférences intérieure et extérieure, et les écarts entre Tmax, d'une part, et Tm1 et Tm2, d'autre part, vont en décroissant.

Le plateau support 22, la cale 24, les entretoises 12 et l'écran 28 sont en un matériau non susceptible de se coupler avec l'inducteur 50, par exemple en oxyde réfractaire tel que l'alumine ou la silice, ou en céramique. Ce matériau peut être massif ou être constitué par une texture fibreuse compacte, par exemple un feutre dense. Par leur caractère isolant thermique, le plateau support 22 et l'écran 28 s'opposent à des déperditions thermiques aux extrémités de la pile 20. De la sorte, toutes les préformes 10 sont soumises aux mêmes conditions de température.

Par ailleurs, on notera qu'un gradient de température est établi entre les circonférences intérieure et extérieure des préformes 10, mais non entre leurs faces planes principales. De la sorte, une température sensiblement égale peut être observée le long d'une ligne verticale de la pile 20. De plus, dans chaque zone élémentaire verticale d'une préforme, sur l'épaisseur de celle-ci, la densification se produit de façon isobare et isotherme.

### EXEMPLE

Un chargement du type de celui illustré par la figure 1 a été réalisé avec des préformes annulaires de disques de frein en fibres de carbone à précurseur polyacrylonitrile préoxydé. Les préformes sont formées de strates de fibres de carbone superposées et aiguilletées comme décrit dans le document US-A-4 790 052, le taux volumique de fibres étant égal à 25 %.

Les préformes sont toutes de mêmes dimensions, à savoir un diamètre intérieur de 120 mm, un diamètre extérieur de 370 mm et une épaisseur de 40 mm. Des espaces de 3 mm sont ménagés entre préformes empilées au moyen d'entretoises en silice.

Un ensemble de 6 préformes est densifié simultanément en utilisant une phase gazeuse constituée, en volume, de 25 % de propane et 75 % de gaz naturel. L'inducteur est alimenté sous une fréquence de 1 500 Hz et à une puissance permettant de porter les zones les plus chaudes des préformes à une température de 1030°C. La température la plus élevée est contrôlée au moyen d'un capteur situé au niveau de la circonférence médiane d'une préforme. Les températures minimales, au niveau des circonférences intérieure et extérieure, mesurées au moyen de capteurs, sont égales à environ 930°C à 950°C au début du processus d'infiltration.

La densification est poursuivie jusqu'à laisser une porosité résiduelle de 10 %. La durée nécessaire est de 300 heures. Une observation au microscope optique d'un échantillon découpé dans un disque obtenu montre une densification satisfaisante.

A titre de comparaison, un processus de densification conduit sur un chargement de préformes identiques, mais dans des conditions isothermes isobares, sensiblement comme décrit dans le document WO-A-96/33295, a nécessité un écroûtage intermédiaire et une durée totale de 800 heures pour parvenir au même niveau de densification.

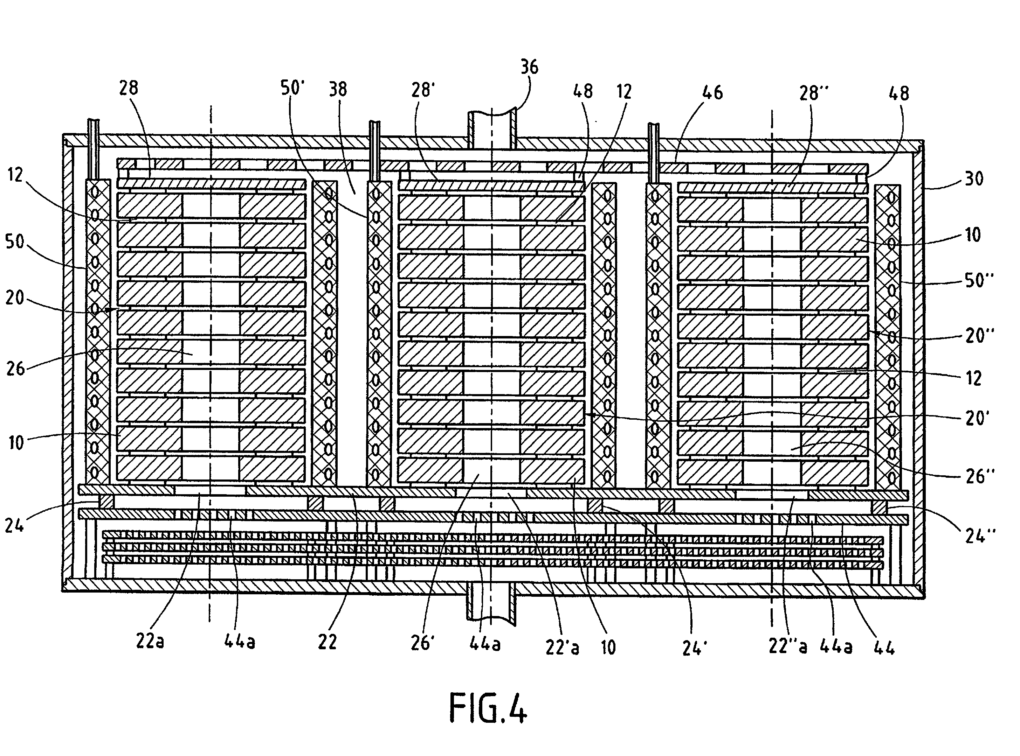

La figure 4 illustre une variante de mise en oeuvre du procédé de la figure 1.

Selon cette variante, plusieurs piles verticales 20, 20', 20" de préformes 10 sont disposées dans la même chambre de réaction 30. Chaque pile 20, 20', 20" est entourée par un inducteur 50, 50', 50" qui lui est propre. Des écrans (non représentés) peuvent être disposés afin d'éviter des interactions entre inducteurs.

Les piles 20, 20', 20" et inducteurs 50, 50', 50" reposent sur le même plateau support 22. Celui-ci est muni de trous 22a, 22'a, 22"a alignés verticalement avec les passages centraux 26, 26', 26" des piles de préformes. La phase gazeuse issue du plateau diffuseur 22 est canalisée vers les passages 26, 26', 26". A cet effet, les cales 24, 24', 24" disposées entre le plateau support 22 et le plateau diffuseur 44 sont des bagues qui entourent les trous 22a, 22'a, 22"a, et le plateau diffuseur 44 est muni de perforations 44a uniquement au regard des passages 26, 26', 26". Des écrans 28, 28', 28" obturent les passages 26, 26', 26" à leur extrémité supérieure.

De la sorte, la phase gazeuse canalisée vers les passages 26, 26', 26" s'écoule de l'intérieur des piles 20, 20', 20" vers l'extérieur, dans le volume 38 d'où elle est évacuée à travers la conduite d'évacuation 36. Un plateau supérieur perforé 46 peut être disposé au-dessus des piles 20, 20', 20" afin d'homogénéiser l'écoulement des gaz résiduels dans le volume 38. Le plateau 46 repose sur les écrans 28, 28', 28" par des pieds 48 en matériau réfractaire non conducteur de l'électricité, identique par exemple au matériau du plateau support 22, des entretoises 12 entre les préformes 10, et des écrans 28.

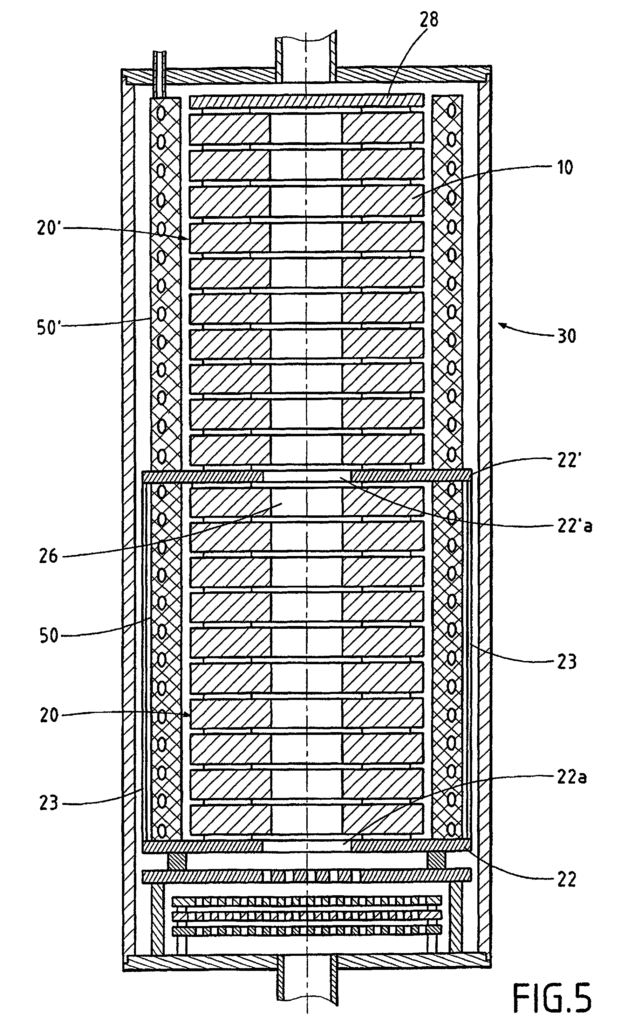

La variante de réalisation de la figure 4 permet d'augmenter le nombre de préformes densifiées simultanément. Il est envisageable aussi, comme montré par la figure 5, de disposer plusieurs piles verticales 20, 20' de préformes 10, avec leurs inducteurs associés 50, 50', le long d'un même axe vertical dans la chambre de réaction 30. Les piles et inducteurs reposent sur des supports respectivement inférieur 22 et intermédiaire 22' munis de trous 22a, 22'a alignés avec les ouvertures centrales des préformes pour former un passage continu 26 où la phase gazeuse est canalisée. Le passage 26 est fermé à son extrémité supérieure par un écran 28. Le support intermédiaire 22' repose sur le support inférieur 22 par l'intermédiaire de pieds 23. Les inducteurs 50, 50' sont formés de bobines cimentées refroidies par eau. Les circuits d'alimentation électrique et de refroidissement des inducteurs sont reliés en série à travers le plateau support intermédiaire 22'. Bien entendu, les variantes de réalisation des figures 4 et 5 peuvent être combinées en disposant dans une même chambre de réaction plusieurs ensembles comprenant chacun plusieurs piles verticales de préformes alignées verticalement.

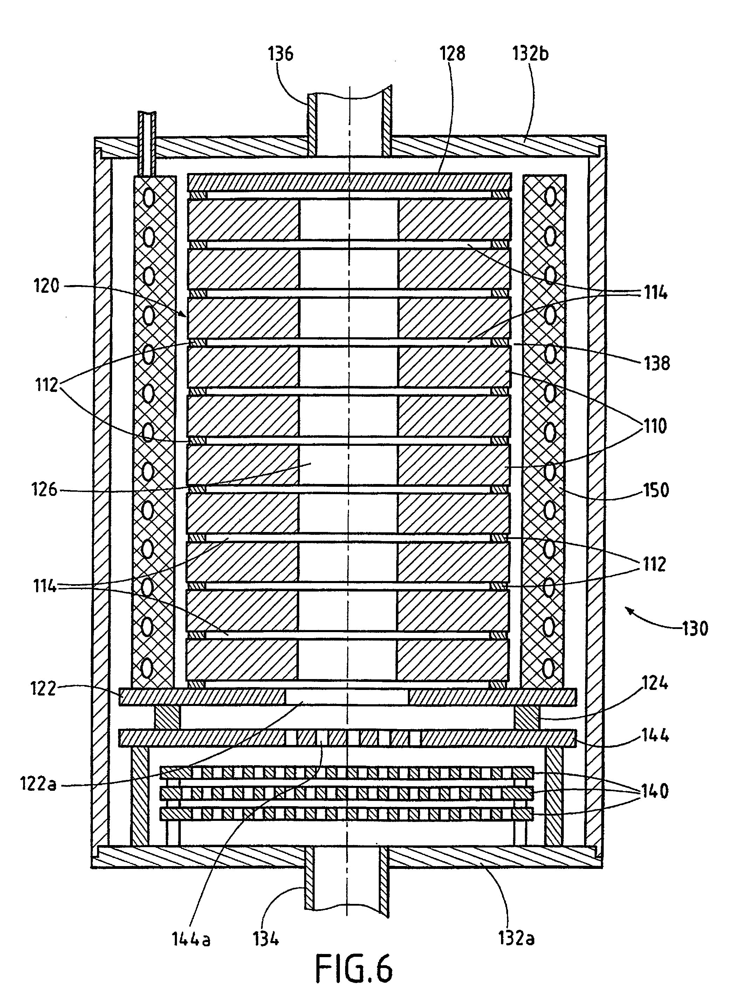

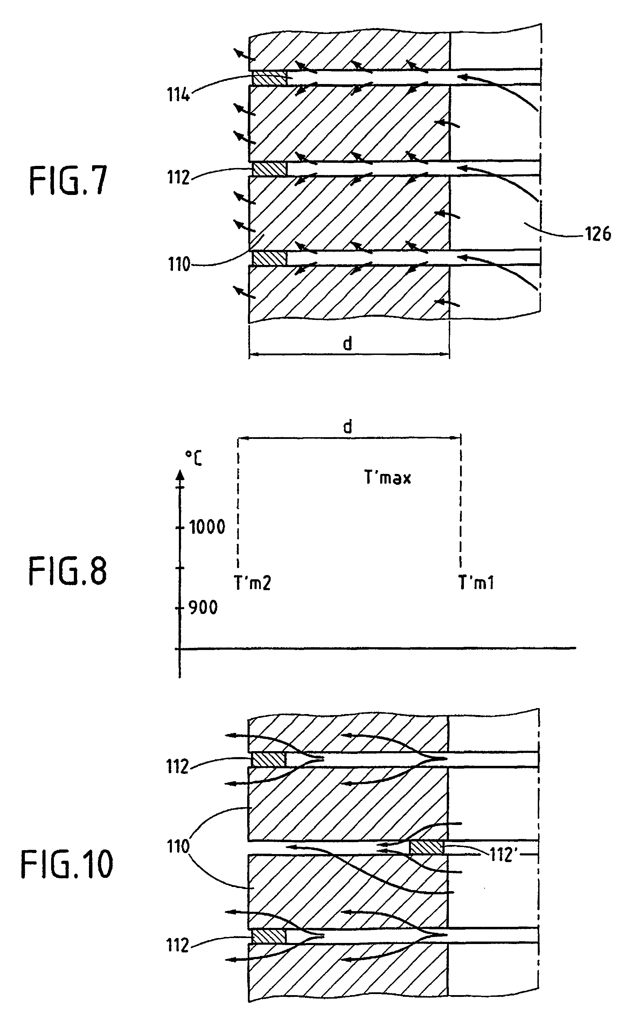

Les figures 6 et 7 illustrent un autre mode de mise en oeuvre de l'invention dans le cas d'une infiltration chimique en phase vapeur avec flux forcé établissant un gradient de pression au sein des préformes à densifier.

Le mode de réalisation de la figure 6 se distingue de celui de la figure 1 par le fait que les entretoises 112 entre les préformes 110 sont constituées de bagues pleines qui isolent les espaces 114 entre préformes de l'extérieur de la pile 120, les bagues étant, dans cet exemple, toutes disposées au niveau de la périphérie des préformes.

La phase gazeuse admise par la conduite d'alimentation 134 qui traverse le fond 132a de la chambre de réaction 130 est préchauffée par passage à travers les plateaux de préchauffage perforés 140. La. phase gazeuse passe ensuite à travers les trous 144a du plateau diffuseur 144 et parvient au passage interne 126 de la pile 120 à travers le trou central 122a du plateau support 122. Le plateau support 122 repose sur le plateau diffuseur 144 par l'intermédiaire d'une entretoise 124 en forme de bague entourant le trou 122a. Le passage 126 est fermé à sa partie supérieure par un écran 128.

Le chauffage des préformes est réalisé par couplage inductif direct au moyen d'un inducteur 150 cimenté refroidi par circulation d'eau, identique à l'inducteur 50 de la figure 1.

La phase gazeuse parvenant dans le passage interne 126 de la pile de préformes ne peut s'écouler vers le volume 138 de la chambre 130 extérieur à la pile qu'en diffusant à travers les préformes 110 (figure 7). La perte de charge qui en résulte se traduit par une différence de pression entre l'intérieur et l'extérieur de la pile. Les gaz résiduels sont extraits du volume 138 par une conduite d'évacuation 136 traversant le couvercle 132b.

Le chauffage inductif des préformes engendre au sein de celles-ci un gradient de température. Il est souhaitable que les zones les plus chaudes des préformes 110 soient éloignées des surfaces qui sont les premières au contact de la phase gazeuse. Le dépôt de la matrice se faisant préférentiellement dans les parties les plus chaudes, et/ou à plus forte pression ponctuelle en cas de dépôt réactif, on peut ainsi éviter un colmatage prématuré de la porosité au niveau des surfaces d'entrée de la phase gazeuse et de sortie des gaz résiduels. Le profil de température le long d'un rayon d'une préforme, entre la circonférence intérieure et la circonférence extérieure a ainsi de préférence l'allure représentée sur la figure 8. La température croît d'une valeur T'm1, au niveau de la circonférence intérieure, jusqu'à un maximum T'max dans une zone médiane, et décroît jusqu'à une valeur T'm2 au niveau de la circonférence extérieure qui fait face à l'inducteur refroidi. Un tel profil peut être obtenu en favorisant l'effet de peau de façon plus prononcée que dans le cas de la figure 3. Dans des conditions d'infiltration analogues (même précurseur de carbone), les valeurs de T'max, d'une part, et de T'm1 et T'm2, d'autre part, peuvent être proche de celles de Tmax, et de Tm1 et Tm2 du mode de réalisation des figures 1 à 3.

Les gaz résiduels parvenus à l'extérieur de la pile 120 sont extraits du volume 138 de la chambre par une conduite d'évacuation passant à travers le couvercle 132b.

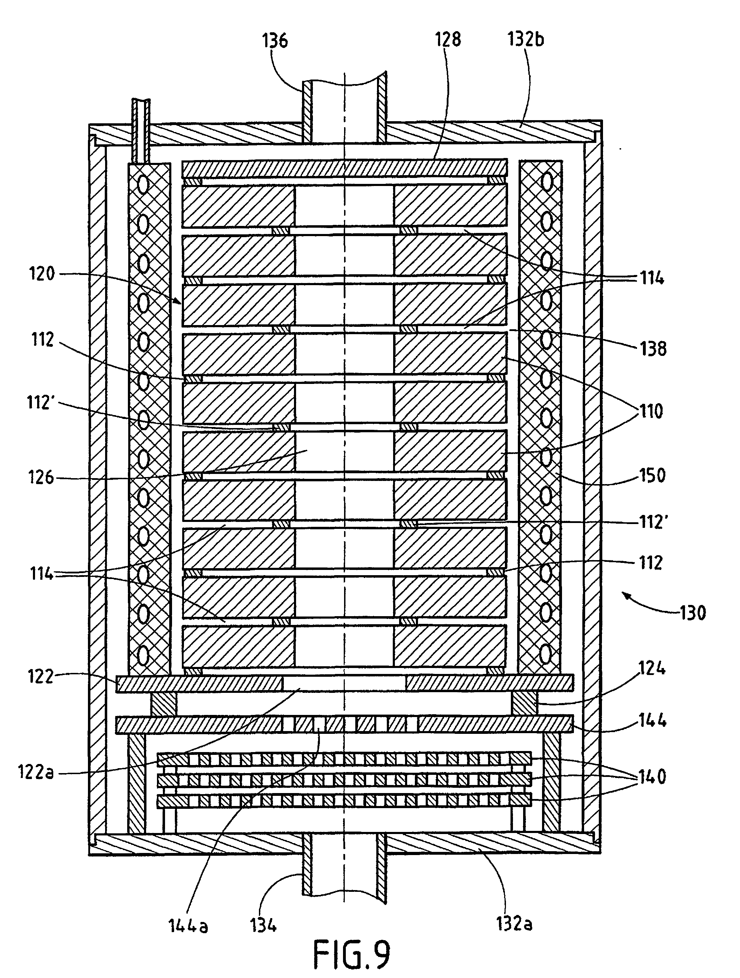

Une variante du procédé illustré par les figures 6 à 8 est montrée par les figures 9 et 10.

On retrouve la chambre de réaction 130 contenant un induit 150 entourant une pile 120 de préformes 110.

Des entretoises 112, 112' sont disposées entre les préformes 110, ainsi qu'entre le plateau 122 et la préforme située au bas de la pile et entre la préforme située au sommet de la pile et l'écran 128.

Dans cette variante de réalisation, les entretoises 112 placées au voisinage du bord périphérique externe des préformes 110, comme dans le mode de réalisation de la figure 6, alternent avec des entretoises 112' placées au voisinage du bord périphérique interne des préformes 110. Les entretoises 112, 112' sont sous forme de bagues pleines qui isolent de façon étanche le passage central 126 du volume 128 de la chambre 130, à l'extérieur de la pile 120.

La phase gazeuse est donc forcée à s'écouler à travers les préformes 110 de la façon montrée par des flèches sur la figure 10. Le chauffage inductif des préformes engendre en leur sein un gradient de température comme dans le cas du procédé de la figure 6.

La disposition alternée des entretoises 112, 112', sur la hauteur de la pile, permet d'augmenter la surface de sortie des gaz ayant traversé les préformes et ainsi de prolonger la densification avant d'aboutir à une différence de pression trop importante entre l'intérieur et l'extérieur de la pile, pouvant engendrer une nucléation en phase homogène (dépôt de suies) à l'intérieur de la pile.

Dans les modes de réalisation envisagés ci-avant, la phase gazeuse circule du bas vers le haut de la chambre de réaction.

Il est possible d'adopter un sens de circulation inverse, la phase gazeuse étant admise au sommet de la pile et les gaz résiduels étant extraits à la base de la pile. Dans ce cas, le préchauffage et la répartition de la phase gazeuse sont réalisés au moyen de plateaux situés au-dessus de la pile de préformes et éventuellement supportés par celle-ci.

Des variantes de mise en oeuvre du procédé des figures 6 et 9 avec plusieurs piles verticales munies de leurs inducteurs correspondants et disposées dans une même chambre de réaction, peuvent être réalisées, d'une façon semblable à celle décrite en référence aux figures 4 et 5, les espaces entre préformes dans les piles étant toutefois fermés pour ne pas ménager de passages de fuite.

Dans ce qui précède, on a envisagé le cas où la phase gazeuse est admise à l'intérieur des piles de préformes, et s'écoule vers l'extérieur, en flux dirigé ou en flux forcé. Il est possible de prévoir une circulation inverse. La phase gazeuse est alors canalisée dans le volume de la chambre situé à l'extérieur de la ou des piles de préformes, volume fermé à son extrémité opposée à celle d'admission de la phase gazeuse. Les gaz résiduels sont alors extraits du ou des volumes intérieurs des piles. Dans le cas de la figure 6, les entretoises doivent alors être placées au voisinage de la périphérie interne des préformes.

De plus, bien que les fibres de carbone soient préférées pour former des préformes ayant les caractéristiques souhaitées de résistivité électrique et conductivité thermique, d'autres fibres peuvent convenir, telles que des fibres de graphite, ou d'autres fibres, de préférence réfractaires, telles que des fibres en céramique, revêtues de carbone ou de graphite.

De plus encore, des préformes réalisées autrement que par empilement et aiguilletage de strates peuvent être utilisées, par exemple des préformes de feutre ayant un taux volumique de fibres relativement élevé, égal de préférence à au moins 15 %, de préférence encore au moins 25 %.

Enfin, dans les cas où la chambre de réaction contient une seule pile verticale de préformes ou plusieurs piles verticales superposées, il est possible de disposer l'inducteur ou les inducteurs à l'extérieur de la chambre de réaction. La paroi de la chambre entourant la pile ou les piles de préformes est alors réalisée en un matériau réfractaire transparent aux ondes électromagnétiques, par exemple en silice. Cette disposition permet d'utiliser une phase gazeuse non nécessairement chimiquement compatible avec le matériau du manchon 54, par exemple une phase gazeuse contenant du méthyltrichlorosilane, précurseur du carbure de silicium.

## Revendications

1. Procédé d'infiltration chimique en phase vapeur pour la densification de substrats poreux présentant une ouverture centrale, le procédé comprenant :
- le chargement des substrats à densifier à l'intérieur d'une chambre de réaction d'une installation d'infiltration, les substrats étant disposés en au moins une pile annulaire qui s'étend dans une direction longitudinale de la chambre et qui délimite un passage intérieur avec des espaces ménagés entre des substrats ;
- le chauffage des substrats ;
- l'admission, au voisinage d'une première extrémité longitudinale de la chambre de réaction, d'une phase gazeuse contenant au moins un précurseur du matériau à déposer ;
- la canalisation de la phase gazeuse admise dans la chambre de réaction vers l'un des deux volumes constitués par l'intérieur et l'extérieur de la ou des piles de substrats, à son extrémité la plus proche de la première extrémité longitudinale de la chambre, le volume dans lequel la phase gazeuse est canalisée étant fermé à son extrémité la plus éloignée de la première extrémité longitudinale de la chambre ; et
- l'évacuation de gaz résiduels hors de la chambre de réaction ;
**caractérisé en ce que**
- les substrats sont chauffés de façon non uniforme par couplage inductif direct avec un inducteur entourant la pile, avec établissement d'un gradient de température au sein de chaque substrat, de sorte que des parties des substrats éloignées de leurs surfaces exposées à la phase gazeuse admise aient une température supérieure à celle des surfaces exposées.

2. Procédé selon la revendication 1 pour la densification de substrats annulaires, **caractérisé en ce qu'**un gradient de température est établi entre une partie des substrats située entre leurs circonférences intérieure et extérieure et des parties des substrats situées au voisinage des circonférences intérieure et extérieure.

3. Procédé selon l'une quelconque des revendications 1 et 2, **caractérisé en ce que** les substrats sont portés sensiblement à la même température le long d'une ligne parallèle à la direction longitudinale de la chambre.

4. Procédé selon l'une quelconque des revendications 1 à 3, **caractérisé en ce que** l'on charge les substrats à l'intérieur de la chambre de réaction en plusieurs piles annulaires.

5. Procédé selon la revendication 4, **caractérisé en ce que** l'on charge les substrats à l'intérieur de la chambre de réaction en formant au moins un ensemble comprenant plusieurs piles annulaires alignées dans la direction longitudinale de la chambre et ayant des passages intérieurs communiquant entre eux.

6. Procédé selon l'une quelconque des revendications 1 à 5, **caractérisé en ce que** l'on place un inducteur autour de la ou chaque pile, à l'intérieur de la chambre de réaction.

7. Procédé selon la revendication 6, **caractérisé en ce que** l'on utilise un inducteur comprenant une bobine d'induction refroidie par circulation d'un fluide.

8. Procédé selon l'une quelconque des revendications 1 à 5, **caractérisé en ce que** l'on place un inducteur autour de la ou chaque pile, à l'extérieur de la chambre de réaction.

9. Procédé selon l'une quelconque des revendications 1 à 8, **caractérisé en ce que** l'on alimente l'inducteur par un courant dont la fréquence est comprise entre 150 Hz et 10 000 Hz.

10. Procédé selon l'une quelconque des revendications 1 à 9, **caractérisé en ce que** l'on ferme le volume dans lequel la phase gazeuse est canalisée par un isolant thermique à l'extrémité de la pile opposée à celle où la phase gazeuse est admise.

11. Procédé selon l'une quelconque des revendications 1 à 10, **caractérisé en ce que** l'on ménage entre des substrats formant une pile annulaire des espaces faisant communiquer l'intérieur de la pile avec l'extérieur de la pile, de sorte que la phase gazeuse peut circuler dans ces espaces entre l'intérieur et l'extérieur de la pile, ou inversement.

12. Procédé selon l'une quelconque des revendications 1 à 10, **caractérisé en ce que** l'on ménage entre des substrats formant une pile annulaire des espaces fermés, de sorte que la circulation de la phase gazeuse entre l'intérieur et l'extérieur de la pile, ou inversement, se fait de façon forcée à travers les substrats.

13. Procédé selon la revendication 12, **caractérisé en ce que** l'on dispose entre les substrats des entretoises annulaires disposées alternativement au voisinage des bords périphériques externes des substrats et des bords périphériques internes des substrats.

14. Procédé selon l'une quelconque des revendications 1 à 13, **caractérisé en ce que** la phase gazeuse est canalisée vers le volume constitué par l'intérieur de la ou des piles de substrats et les gaz résiduels sont évacués du volume constitué par l'extérieur de la ou des piles de substrats.

15. Procédé selon l'une quelconque des revendications 1 à 14 pour la réalisation de disques de freins en matériau composite carbone-carbone, **caractérisé en ce que** l'on forme au moins une pile annulaire de substrats constitués par des préformes annulaires de disques de frein en fibres de carbone et l'on admet dans la chambre de réaction une phase gazeuse contenant au moins un précurseur de carbone pyrolytique.

16. Procédé selon la revendication 15, **caractérisé en ce que** les préformes sont formées de strates de fibres de carbone aiguilletées.

17. Procédé selon l'une quelconque des revendications 1 à 16, **caractérisé en ce que** les substrats poreux sont des substrats fibreux ayant un taux volumique de fibres au moins égal à 15 %.

## Patentansprüche

1. Verfahren zum chemischen Infiltrieren aus der Dampfphase zur Verdichtung von porösen Substraten mit einer Mittelöffnung, umfassend:
- das Einbringen von zu verdichtenden Substraten in das Innere einer Reaktionskammer einer Infiltrationsanlage, wobei die Substrate in mindestens einem ringförmigen Stapel angeordnet sind, der sich in einer Längsrichtung der Kammer erstreckt, und der mit den zwischen den Substraten gebildeten Zwischenräumen einen Innenkanal begrenzt;
- Erhitzen der Substrate;
- Einleiten einer mindestens einen Vorläufer des niederzuschlagenden Materials enthaltenden Gasphase in der Nachbarschaft eines ersten längsseitigen Endes der Reaktionskammer;
- das Lenken der in die Reaktionskammer eingeleiteten Gasphase zu einem der beiden Volumina, die durch das Innere und das Äußere des oder der Substratstapel gebildet werden, an demjenigen Ende des Volumens, das dem ersten längsseitigen Ende der Kammer am nächsten liegt, wobei das Volumen, in das die Gasphase gelenkt wird, an seinem von dem ersten längsseitigen Ende der Kammer am weitesten entfernten Ende verschlossen ist; und
- Ausleiten von Restgasen aus der Reaktionskammer;
**dadurch gekennzeichnet, dass** die Substrate in ungleichförmiger Weise erhitzt werden durch direkte induktive Kopplung mit einer den Stapel umgebenden Feldwicklung unter Schaffung eines Temperaturgradienten im Inneren jedes Substrats derart, dass Teile der Substrate, die von deren der Gasphase exponierten Oberflächen entfernt sind, eine Temperatur haben, die über derjenigen der exponierten Oberflächen liegt.

2. Verfahren nach Anspruch 1, **dadurch gekennzeichnet, dass** zwischen einem Teil der Substrate, die zwischen ihren Innenumfängen und ihren Außenumfängen liegen, und Teilen der Substrate, die in der Nachbarschaft der Innen- und Außenumfänge gelegen sind, ein Temperaturgradient erzeugt wird.

3. Verfahren nach Anspruch 1 und 2, **dadurch gekennzeichnet, dass** die Substrate entlang einer Linie parallel zu der Längsrichtung der Kammer auf im Wesentlichen der gleichen Temperatur gehalten werden.

4. Verfahren nach einem der Ansprüche 1 bis 3, **dadurch gekennzeichnet, dass** man die Substrate in Form mehrerer Ringstapel in das Innere der Reaktionskammer einbringt.

5. Verfahren nach Anspruch 4, **dadurch gekennzeichnet, dass** man die Substrate in das Innere der Reaktionskammer einbringt, indem man mindestens eine Garnitur aus mehreren in Längsrichtung der Kammer ausgerichteten Ringstapeln bildet, die untereinander kommunizierende Innenkanäle aufweisen.

6. Verfahren nach einem der Ansprüche 1 bis 5, **dadurch gekennzeichnet, dass** man um jeden Stapel herum im Inneren der Reaktionskammer eine Feldwicklung plaziert.

7. Verfahren nach Anspruch 6, **dadurch gekennzeichnet, dass** man eine Feldwicklung verwendet, die eine durch Zirkulation eines Fluids gekühlte Induktionsspule aufweist.

8. Verfahren nach einem der Ansprüche 1 bis 5, **dadurch gekennzeichnet, dass** man um jeden Stapel herum außerhalb der Reaktionskammer eine Feldspule anordnet.

9. Verfahren nach einem der Ansprüche 1 bis 8, **dadurch gekennzeichnet, dass** man die Feldspule mit einem Strom einer Frequenz zwischen 150 Hz und 10000 Hz speist.

10. Verfahren nach einem der Ansprüche 1 bis 9, **dadurch gekennzeichnet, dass** man das Volumen, in das die Gasphase gelenkt wird, an einem Ende des Stapels, das dem Ende, wo die Gasphase eingeleitet wird, abgewandt ist, mit einem Wärmeisoliermittel verschließt.

11. Verfahren nach einem der Ansprüche 1 bis 10, **dadurch gekennzeichnet, dass** man zwischen den einen Ringstapel bildenden Substraten Zwischenräume bildet, die das Innere des Stapels mit dem Äußeren des Stapels derart verbinden, dass die Gasphase in diesen Zwischenräumen zwischen dem Inneren und dem Äußeren des Stapels oder umgekehrt zirkulieren kann.

12. Verfahren nach einem der Ansprüche 1 bis 10, **dadurch gekennzeichnet, dass** man zwischen den einen Ringstapel bildenden Substraten geschlossene Zwischenräume bildet derart, dass die Zirkulation der Gasphase zwischen dem Inneren und dem Äußeren des Stapels oder umgekehrt zwangsweise durch die Substrate hindurch erfolgt.

13. Verfahren nach Anspruch 12, **dadurch gekennzeichnet, dass** man zwischen den Substraten Ringstege anordnet, die abwechselnd in der Nachbarschaft der äußeren Umfangsränder der Substrate und der inneren Umfangsränder der Substrate angeordnet werden.

14. Verfahren nach einem der Ansprüche 1 bis 13, **dadurch gekennzeichnet, dass** die Gasphase in Richtung des Volumens gelenkt wird, das durch das Innere des oder der Substratstapel gebildet wird, und die Restgase aus dem Volumen entfernt werden, das durch das Äußere des oder der Substratstapel gebildet wird.

15. Verfahren nach einem der Ansprüche 1 bis 14 zur Fertigung von Bremsscheiben aus Kohlenstoff-Kohlenstoff-Verbundwerkstoff, **dadurch gekennzeichnet, dass** man mindestens einen Ringstapel aus Substraten bildet, die durch ringförmige Vorformlinge der Bremsscheiben aus Kohlenstofffasern bestehen, und man in die Reaktionskammer eine Gasphase einleitet, die mindestens einen Vorläufer von pyrolytischem Kohlenstoff enthält.

16. Verfahren nach Anspruch 15, **dadurch gekennzeichnet, dass** die Vorformlinge aus genadelten Kohlenstofffaser-Lagen gebildet werden.

17. Verfahren nach einem der Ansprüche 1 bis 16, **dadurch gekennzeichnet, dass** die porösen Substrate Fasersubstrate sind, die einen Faser-Volumenanteil von mindestens 15% besitzen.

## Claims

1. A chemical vapour infiltration method for densifying porous substrates having a central opening, the method comprising:
- loading substrates to be densified inside a reaction chamber of an infiltration installation, the substrates being disposed in at least one annular stack extending in a longitudinal direction of the chamber and defining an inside passage with gaps formed between the substrates;
- heating the substrates;
- admitting a gas to the vicinity of a first longitudinal end of the reaction chamber, the gas containing at least one precursor of the material to be deposited;
- channeling the gas admitted into the reaction chamber towards one of the two volumes constituted by the inside and the outside of the stack(s) of substrates, to the end thereof that is closer to the first longitudinal end of the chamber, the volume into which the gas phase is channeled being closed at its end further from the first longitudinal end of the chamber; and
- evacuating the residual gas from the reaction chamber; the method being **characterised in that**:
- the substrates are heated in non-uniform manner by direct inductive coupling with an induction primary surrounding the stack, with the establishment of a temperature gradient within each substrate so that the substrate portions remote from the substrate surfaces exposed to the admitted gas are at a temperature higher than that of the exposed surfaces.

2. A method according to claim 1 for densifying annular substrates, the method being **characterised in that** a temperature gradient is established between a portion of each substrate situated between its inside and outside circumferences, and portions of the substrates situated in the vicinity of the inside and outside circumferences.

3. A method according to claim 1 or 2, **characterised in that** the substrates are raised to substantially the same temperature along a line parallel to the longitudinal direction of the chamber.

4. A method according to any one of claims 1 to 3, **characterised in that** the substrates are loaded into the inside of the reaction chamber in a plurality of annular stacks.

5. A method according to claim 4, **characterised in that** the substrates are loaded into the inside of the reaction chamber by forming at least one assembly comprising a plurality of annular stacks that are in alignment in the longitudinal direction of the chamber and that have inside passages that are in communication with one another.

6. A method according to any one of claims 1 to 5, **characterised in that** an induction primary is placed around the or each stack inside the reaction chamber.

7. A method according to claim 6, **characterised in that** an induction primary is used that comprises an induction coil that is cooled by circulating a fluid.

8. A method according to any one of claims 1 to 5, **characterised in that** an induction primary is placed around the or each stack outside the reaction chamber.

9. A method according to any one of claims 1 to 8, **characterised in that** the induction primary is powered at a frequency lying in the range 150 Hz to 10,000 Hz.

10. A method according to any one of claims 1 to 9, **characterised in that** the volume into which the gas is channeled is closed by a thermal insulator at the end of the stack remote from the end at which the gas is admitted.

11. A method according to any one of claims 1 to 10, **characterised in that** gaps are formed between substrates forming an annular stack to allow the inside of the stack to communicate with the outside of the stack so that the gas can flow through said gaps between the inside and the outside of the stack, or in the opposite direction.

12. A method according to any one of claims 1 to 10, **characterised in that** closed gaps are formed between the substrates forming an annular stack so that the flow of gas between the inside and the outside of the stack, or in the opposite direction, takes place in forced manner through the substrates.

13. A method according to claim 12, **characterised in that** annular spacers are disposed between the substrates which spacers are disposed alternately in the vicinity of the outer peripheral edges of the substrates and of the inner peripheral edges of the substrates.

14. A method according to any one of claims 1 to 13, **characterised in that** the gas is channeled towards the volume constituted by the inside(s) of the stack(s) of substrates, and the residual gas is exhausted from the volume constituted by the outside of the stack(s) of substrates.

15. A method according to any one of claims 1 to 14, for making brake disks of carbon-carbon composite material, the method being **characterised in that** at least one annular stack is formed of substrates constituted by annular carbon fiber brake disk preforms, and gas is admitted into the reaction chamber containing at least one precursor of pyrolytic carbon.

16. A method according to claim 15, **characterised in that** the preforms are made up of needled-together plies of carbon fibers.

17. A method according to any one of claims 1 to 16, **characterised in that** the porous substrates are fiber substrates having a fiber volume fraction of not less than 15%.
